# EUROPÄISCHE PATENTANMELDUNG

(11) **EP 1 933 462 A2**
(43) Veröffentlichungstag der Anmeldung: **18.06.2008**
(21) Anmeldenummer: 07023318.4
(22) Anmeldetag: 01.12.2007
(51) Int. Cl.: H03K 17/96

(54) **Optischer Sensor**

(30) Priorität: 15.12.2006 DE 102006059850
(71) Anmelder: Diehl AKO Stiftung & Co. KG, 88239 Wangen (DE)
(72) Erfinder: Arnold, Georg, 91126 Schwabach (DE)
(74) Vertreter: Diehl Patentabteilung

(57) **Zusammenfassung**

Es wird ein optischer Sensor für einen berührungsempfindlichen Tastschalter einer Bedienungseinrichtung eines elektronischen Haushaltsgeräts vorgeschlagen, der einen elektromagnetische Strahlung aussendenden Sender (12); einen elektromagnetische Strahlung empfangenden Empfänger (14); eine für die elektromagnetische Strahlung zumindest teildurchlässigen Abdeckung (24), hinter der der Sender (12) und der Empfänger (14) angeordnet sind; und eine Strahlungsleiteinrichtung (16) zum Beispiel in Form eines Blendenrahmens, die zwischen dem Sender (12) und dem Empfänger (14) einerseits und der Abdeckung (24) andererseits vorgesehen ist, um die vom Sender (12) ausgesendete Strahlung zur Abdeckung (24) zu leiten und die durch die Abdeckung (24) eindringende reflektierte Strahlung zum Empfänger (14) zu leiten, aufweist. Weiter ist der Blendenrahmen (16) so ausgebildet, dass die Abstrahlcharakteristik (26) des Senders (12) aus der Abdeckung (24) heraus und/oder die Empfangscharakteristik (28) des Empfängers (14) in die Abdeckung (24) hinein verbreitert sind, und zusätzlich oder alternativ so ausgebildet, dass die Abstrahlcharakteristik (26) des Senders (12) aus der Abdeckung (24) heraus in Richtung zur Empfangscharakteristik (28) des Empfängers (14) in die Abdeckung (24) hinein geneigt ist und/oder die Empfangscharakteristik (28) des Empfängers (14) in die Abdeckung (24) hinein in Richtung zur Abstrahlcharakteristik (26) des Senders (12) aus der Abdeckung (24) heraus geneigt ist. Bei dieser Konstruktion wird der Kreuzungsbereich von Abstrahlcharakteristik (26) und Empfangscharakteristik (28) nahe zur Abdeckung (24) hin verschoben, sodass der Störabstand des optischen Sensors verringert werden kann.

## Beschreibung

Die vorliegende Erfindung betrifft einen optischen Sensor nach dem Oberbegriff des Anspruchs 1, und insbesondere einen solchen optischen Sensor für einen berührungsempfindlichen Tastschalter, der zur Verwendung in einer Bedienungseinrichtung eines elektronischen Haushaltsgeräts geeignet ist.

Der grundsätzliche Aufbau und das Grundprinzip eines optischen Sensors für einen berührungsempfindlichen Tastschalters sind zum Beispiel aus der DE 40 07 971 A1 bekannt. Der optische Sensor weist einen elektromagnetische Strahlung aussendenden Sender und einen elektromagnetische Strahlung empfangenden Empfänger auf, die hinter einer für die elektromagnetische Strahlung zumindest teildurchlässigen Abdeckung angeordnet sind. Ferner ist im Allgemeinen eine Strahlungsleiteinrichtung zwischen dem Sender und dem Empfänger einerseits und der Abdeckung andererseits vorgesehen, um die vom Sender ausgesendete Strahlung zur Abdeckung zu leiten und die durch die Abdeckung eindringende reflektierte Strahlung zum Empfänger zu leiten.

Im einfachsten Fall besteht diese Strahlungsleiteinrichtung zum Beispiel aus einem Blendenrahmen, der den Sender und den Empfänger umgibt. Zur Erzielung eines besseren Nutzsignal/Störsignal-Verhältnisses ist es weiter bekannt, als Strahlungsleiteinrichtung Lichtleiter einzusetzen, wie dies beispielsweise in der DE 197 00 836 C1 oder der DE 10 2004 025 878 B4 offenbart ist.

Eine vorteilhafte Anwendung derartiger optischer Sensoren ist der Einsatz in berührungsempfindlichen Tastschaltern für Bedienungseinrichtungen von elektronischen Haushaltsgeräten, wie Kochherden, Glaskeramik-Kochfeldern, Mikrowellenherden und dergleichen, bei denen der Tastschalter zur einfachen Bedienung und Reinigung hinter einer Abdeckung, wie beispielsweise einer Glasplatte oder Glaskeramikplatte untergebracht ist.

Der vorliegenden Erfindung liegt die Aufgabe zugrunde, einen optischen Sensor der eingangs beschriebenen Art weiterzuentwickeln, der einen verringerten Störabstand aufweist.

Diese Aufgabe wird gemäß einem ersten Aspekt durch einen optischen Sensor mit den Merkmalen des Anspruchs 1 und gemäß einem zweiten Aspekt durch einen optischen Sensor mit den Merkmalen des Anspruchs 3 gelöst. Vorteilhafte Ausgestaltungen und Weiterbildungen der Erfindung sind Gegenstand der abhängigen Ansprüche.

Die Erfindung betrifft einen optischen Sensor, mit einem elektromagnetische Strahlung aussendenden Sender; einem elektromagnetische Strahlung empfangenden Empfänger; einer für die elektromagnetische Strahlung zumindest teildurchlässigen Abdeckung, hinter der der Sender und der Empfänger angeordnet sind; und einer Strahlungsleiteinrichtung, die zwischen dem Sender und dem Empfänger einerseits und der Abdeckung andererseits vorgesehen ist, um die vom Sender ausgesendete Strahlung zur Abdeckung zu leiten und die durch die Abdeckung eindringende reflektierte Strahlung zum Empfänger zu leiten.

Gemäß dem ersten Aspekt der Erfindung ist der optische Sensor dadurch gekennzeichnet, dass die Strahlungsleiteinrichtung so ausgebildet ist, dass die Abstrahlcharakteristik des Senders aus der Abdeckung heraus und/oder die Empfangscharakteristik des Empfängers in die Abdeckung hinein verbreitert sind.

Die Verbreiterung der Abstrahl- und/oder der Empfangscharakteristik bewirkt, dass der Kreuzungsbereich zwischen Abstrahl- und Empfangscharakteristik näher zur Abdeckung verschoben wird. Als Ergebnis wird das Empfangssignal bei einem auf den optischen Sensor gelegten Finger größer und die Empfangssignalstärke-Abstand-Kurve fällt mit größere werdendem Abstand von der Abdeckung stärker, sodass eine Fehlbedienung durch im Abstand am optischen Sensor vorbei streichende Finger oder durch andere reflektierende Objekte minimiert werden kann. Mit anderen Worten wird der Störabstand des optischen Sensors deutlich reduziert.

Gemäß dem zweiten Aspekt der Erfindung ist der optische Sensor dadurch gekennzeichnet, dass die Strahlungsleiteinrichtung so ausgebildet ist, dass die Abstrahlcharakteristik des Senders aus der Abdeckung heraus in Richtung zur Empfangscharakteristik des Empfängers in die Abdeckung hinein geneigt ist und/oder die Empfangscharakteristik des Empfängers in die Abdeckung hinein in Richtung zur Abstrahlcharakteristik des Senders aus der Abdeckung heraus geneigt ist.

Das Neigen der Abstrahl- und/oder der Empfangscharakteristik in Richtung zur jeweils anderen Charakteristik bewirkt ebenfalls, dass der Kreuzungsbereich zwischen Abstrahl- und Empfangscharakteristik näher zur Abdeckung verschoben wird. Als Ergebnis wird daher auch bei dieser Konstruktion analog zum obigen ersten Aspekt der Störabstand des optischen Sensors deutlich reduziert.

Die Merkmale des ersten und des zweiten Aspekts der Erfindung sind vorzugsweise miteinander kombinierbar, sodass der oben beschriebene Effekt noch verstärkt werden kann.

Falls die Strahlungsleiteinrichtung ein Blendenrahmen ist, der den Sender und den Empfänger umgibt und an seiner der Abdeckung zugewandten Seite eine dem Sender zugeordnete Austrittsöffnung und eine dem Empfänger zugeordnete Eintrittsöffnung aufweist, können zur Erzielung des obigen ersten Aspekts die Innenflächen des Blendenrahmens zumindest teilweise die elektromagnetische Strahlung reflektierend ausgebildet sein; und zur Erzielung des obigen zweiten Aspekts kann der Blendenrahmen in Richtung zur Abdeckung (24) hin nach innen verengt ausgebildet sein.

Falls die Strahlungsleiteinrichtung einen ersten, dem Sender zugeordneten Lichtleiter und einen zweiten, dem Empfänger zugeordneten Lichtleiter aufweist, kann zur Erzielung des obigen ersten Aspekts die der Abdeckung zugewandte Stirnseite des ersten und/oder des zweiten Lichtleiters diffus streuend ausgebildet sein; und zur Erzielung des obigen zweiten Aspekts können der erste und/oder der zweite Lichtleiter in Richtung zur Abdeckung hin nach innen geneigt angeordnet sein und/oder in dem der Abdeckung zugewandten Bereich schräg nach innen verlaufend ausgebildet sein.

Alternativ kann die Strahlungsleiteinrichtung zur Erzielung des obigen ersten Aspekts einen ersten, dem Sender zugeordneten Hohlleiter und einen zweiten, dem Empfänger zugeordneten Hohlleiter aufweisen. In diesem Fall können zur Erzielung des obigen zweiten Aspekts der erste und/oder der zweite Hohlleiter in Richtung zur Abdeckung hin nach innen geneigt angeordnet sein und/oder in dem der Abdeckung zugewandten Bereich schräg nach innen verlaufend ausgebildet sein.

Obige sowie weitere Merkmale und Vorteile der Erfindung werden aus der nachfolgenden Beschreibung bevorzugter, nicht-einschränkender Ausführungsbeispiele unter Bezug auf die beiliegenden Zeichnungen besser verständlich. Darin zeigen:
- Fig. 1: eine schematische Schnittansicht des Aufbaus und der Funktionsweise eines optischen Sensors gemäß einem ersten bevorzugten Ausführungsbeispiel mit einem Blendenrahmen als Strahlungsleiteinrichtung;
- Fig. 2: eine schematische Schnittansicht eines herkömmlichen optischen Sensors mit einem Blendenrahmen zum Vergleich;
- Fig. 3: ein Diagramm zum Vergleichen des Störabstands zwischen den in Fig. 1 und 2 dargestellten optischen Sensoren;
- Fig. 4: eine schematische Schnittansicht des Aufbaus und der Funktionsweise eines optischen Sensors gemäß einem zweiten bevorzugten Ausführungsbeispiel mit Hohlleitern als Strahlungsleiteinrichtung; und
- Fig. 5: eine schematische Schnittansicht des Aufbaus und der Funktionsweise eines optischen Sensors gemäß einem dritten bevorzugten Ausführungsbeispiel mit Lichtleitern als Strahlungsleiteinrichtung.

Nachfolgend werden unter Bezug auf die beiliegenden Zeichnungen verschiedene bevorzugte Ausführungsbeispiele der Erfindung anhand eines optischen Sensors näher erläutert, der für einen berührungsempfindlichen Tastschalter einer Bedienungseinrichtung eines elektronischen Haushaltsgeräts eingesetzt werden kann. Die vorliegende Erfindung ist aber selbstverständlich nicht nur auf diese spezielle Anwendung des optischen Sensors beschränkt.

Ferner wird in den nachfolgend beschriebenen Ausführungsbeispielen als elektromagnetische Strahlung bevorzugt Infrarotstrahlung benutzt, ohne dass die vorliegende nur darauf beschränkt sein soll.

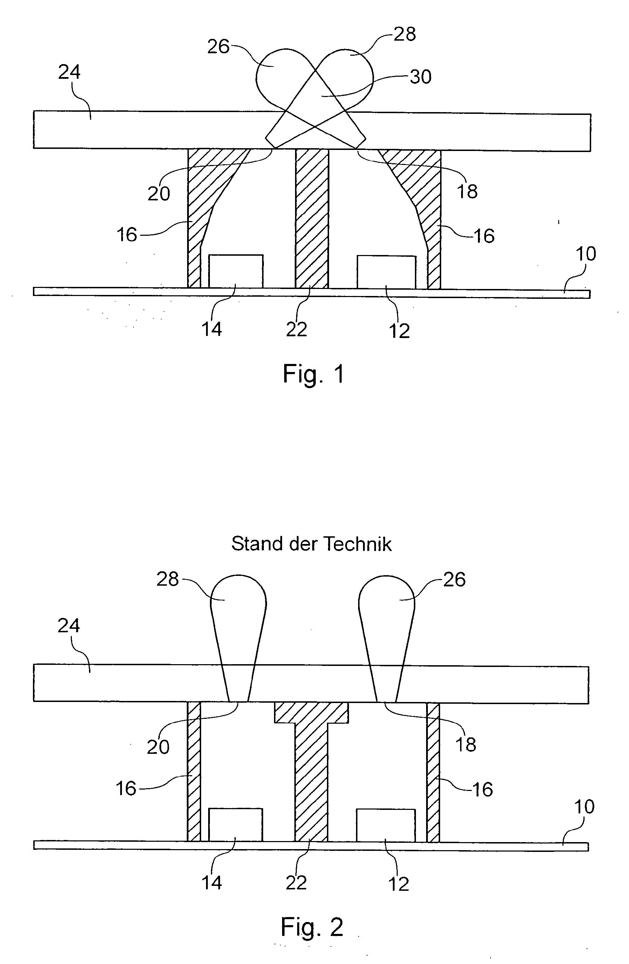

Zunächst werden unter Bezug auf Fig. 1 bis 3 der Aufbau und die Funktionsweise eines optischen Sensors gemäß einem ersten Ausführungsbeispiel näher erläutert.

Der optische Sensor des berührungsempfindlichen Tastschalters weist auf einer Leiterplatte 10 einen Infrarot-Sender 12 und einen Infrarot-Empfänger 14 auf. Der Sender 12 und der Empfänger 14 sind von einem Blendenrahmen 16 umgeben, der an seiner Oberseite eine dem Sender 12 zugeordnete Austrittsöffnung 18 und eine dem Empfänger zugeordnete Eintrittsöffnung 20 aufweist. Der aus einem möglichst IRundurchlässigen Material gebildete Blendenrahmen 16 ist zum Beispiel mit Füßen durch Löcher in der Leiterplatte 10 eingesteckt und so an dieser befestigt.

Der Sender 12 und der Empfänger 14 sind innerhalb von jeweiligen Hohlräumen unterhalb der Blendenöffnungen 18, 20 angeordnet, die vorzugsweise durch eine im Wesentlichen IR-undurchlässige Trennwand 22 voneinander getrennt sind. Direkt auf der Oberseite des Blendenrahmens 16 liegt eine Abdeckung 24 aus einem für Infrarotstrahlung zumindest teildurchlässigen Material, zum Beispiel eine Glaskeramikplatte eines Haushaltskochherdes.

Im herkömmlichen Fall, wie er in Fig. 2 veranschaulicht ist, wird die vom Sender 12 ausgesendete Strahlung durch den Blendenrahmen 16 durch die Austrittsöffnung 18 aus der Abdeckung 24 herausgeleitet, wobei diese Abstrahlcharakteristik 26 des Senders 12, genauer die Abstrahlcharakteristik 26 des Senders 12 aus der Abdeckung 24 heraus, im Wesentlichen eine relativ geradlinige Keulenform aufweist.

Bei einer Betätigung des berührungsempfindlichen Tastschalters durch einen auf die Oberfläche der Abdeckung 24 gelegten Finger wird die Strahlung des Senders 12 diffus und mehrfach gestreut, sodass genügend Streustrahlung auf den Empfänger 14 reflektiert wird und dieser ein entsprechendes Messsignal an eine Auswerteschaltung senden kann, um eine entsprechende Schaltfunktion auszulösen. Die Empfangscharakteristik 28 des Empfängers 14, genauer die Empfangscharakteristik 28 des Empfängers 14 in die Abdeckung 24 hinein, ist analog zur Abstrahlcharakteristik 26 des Senders 12 in einer im Wesentlichen geradlinigen Keulenform im Wesentlichen parallel zur Abstrahlcharakteristik 26 ausgebildet.

Wie ein Vergleich von Fig. 2 (herkömmlicher optischer Sensor) mit Fig. 1 zeigt, ist der Blendenrahmen 16 des optischen Sensors erfindungsgemäß so ausgebildet, dass einerseits die Abstrahlcharakteristik 26 des Senders 12 und die Empfangscharakteristik 28 des Empfängers 14 kugelförmig verbreitert sind und anderseits die Abstrahlcharakteristik 26 und die Empfangscharakteristik 28 aufeinander zu geneigt sind. Wie deutlich in Fig. 1 erkennbar, bewirkt dies, dass der Kreuzungsbereich 30 zwischen Abstrahl- und Empfangscharakteristik 26, 28, der den gesamtempfindlichen Bereich des Sensors darstellt, näher zur Abdeckung 24 hin verschoben wird, was einen deutlich reduzierten Störabstand des so aufgebauten optischen Sensors bewirkt, wie nachfolgend erläutert.

Die Verbreiterung von Abstrahl- und Empfangscharakteristik 26, 28 wird zum Beispiel dadurch erreicht, dass die Innenflächen des Blendenrahmens 16 zumindest teilweise IRreflektierend (Reflexion bevorzugt größer als 45% im relevanten Reflexionsbereich) ausgebildet sind. Der Blendenrahmen 16 sollte weiterhin auch möglichst IRundurchlässig sein, wobei eine Transmission von weniger als 5% im relevanten Reflexionsbereich bevorzugt ist. Diese Eigenschaften des Blendenrahmens 16 können zum Beispiel durch entsprechende Beschichtungen und/oder Materialauswahlen des Blendenrahmens 16 bewirkt werden.

Die Neigung von Abstrahl- und Empfangscharakteristik 26, 28 zueinander wird beispielsweise durch eine entsprechende Formgebung des Blendenrahmens 16, insbesondere eine Verengung des Blendenrahmens in Richtung zur Abdeckung hin nach innen erreicht. Bei einer geeigneten Konstruktion des Blendenrahmens 16 kann der relevante Kreuzungsbereich 30 der Charakteristiken 26, 28 bis in den Oberflächenbereich der Abdeckung 24 hinein gelegt werden. Ein Objekt außerhalb dieses gesamtempfindlichen Bereichs 30 kann so kaum eine Strahlungsreflexion in den Empfänger 14 verursachen.

Die beiden genannten Maßnahmen können sowohl gleichzeitig als auch alternativ zur Anwendung kommen. Ferner ist es im Rahmen der Erfindung auch möglich, entweder nur die Abstrahlcharakteristik 26 oder nur die Empfangscharakteristik 28 wie oben beschrieben zu beeinflussen, auch wenn dies die vorteilhafte Wirkung einschränkt.

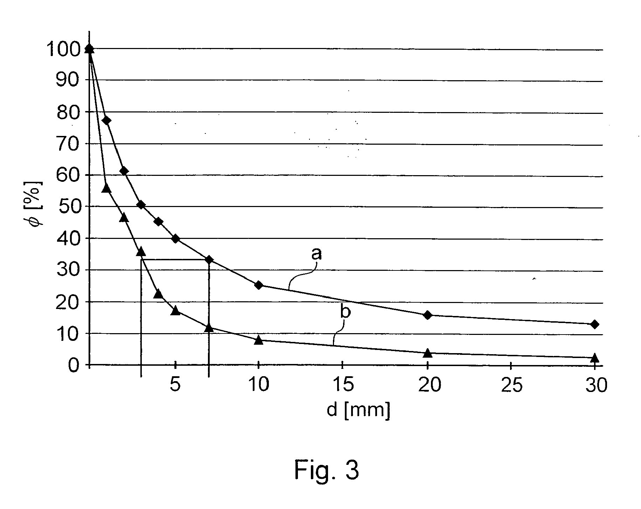

Die Wirkung der erfindungsgemäßen Ausbildung des optischen Sensors ist in Fig. 3 nochmals veranschaulicht.

Fig. 3 zeigt ein Kennliniendiagramm mit einer Kurve "a" für den herkömmlichen optischen Sensor von Fig. 2 und einer Kurve "b" für einen erfindungsgemäßen optischen Sensor gemäß Fig. 1, bei dem nur die Aufweitung, nicht aber die Neigung beider Charakteristiken 26, 28 realisiert ist. Die Abszisse zeigt den Abstand d (in mm) zwischen der Abdeckung 24 und einem Finger; auf der Ordinate ist das Empfangssignalniveau φ (in %) aufgetragen, wobei der Wert für einen auf dem Tastschalter aufliegenden Finger (d=0) auf 100% gesetzt ist.

Wenn zum Beispiel ein herkömmlicher optischer Sensor (Kurve a) bei einem Fingerabstand von d = 7 mm anspricht, dann spricht ein optischer Sensor der Erfindung (Kurve b) bei einem Abstand von d = 3 mm an, wobei das Signal/Rausch-Verhältnis unverändert bleibt. Durch die steilere Signalniveau-Abstand-Kurve b wird der Störabstand des optischen Sensors deutlich vermindert. Das Problem herkömmlicher optischer Sensoren, dass sie bereits bei einer größeren Fingerentfernung ansprechen oder auch sehr schlecht ansprechen, kann auf diese Weise vermieden werden. Ein weiterer Vorteil besteht darin, dass auch das Empfangssignalniveau bei einem auf dem optischen Sensor aufliegenden Finger erhöht ist.

Wie oben dargelegt, kann die Reduzierung des Störabstands des optischen Sensors mit einfachen Mitteln (einem leicht modifizierten Blendenrahmen 16) erreicht werden, sodass der Montageaufwand und die Herstellungskosten gering gehalten werden können.

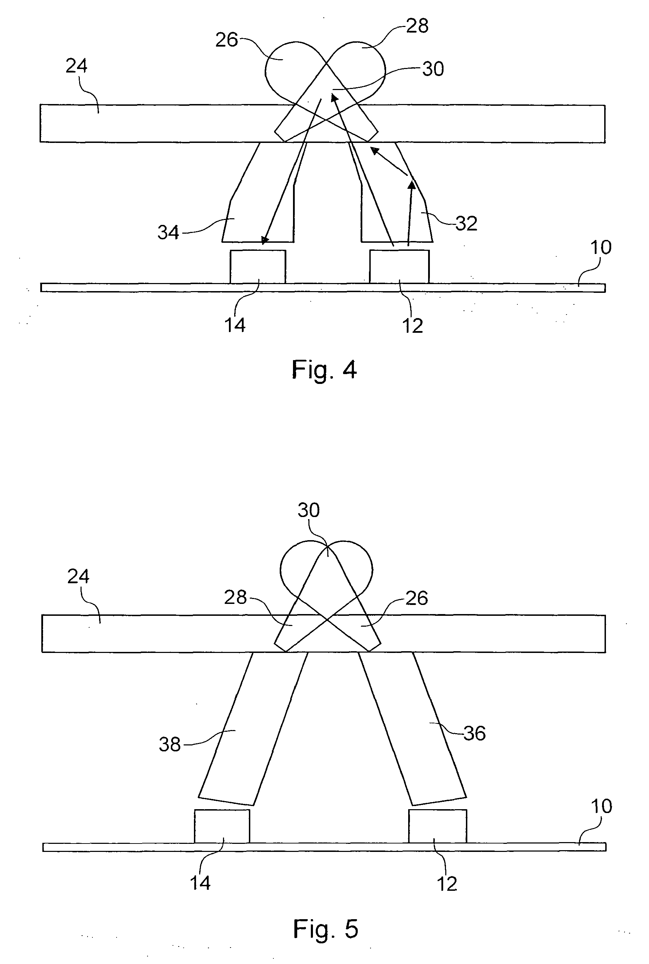

Fig. 4 zeigt schematisch den Aufbau eines optischen Sensors gemäß einem zweiten Ausführungsbeispiel der Erfindung. Gleiche bzw. entsprechende Komponenten sind dabei mit den gleichen Bezugsziffern versehen wie im obigen ersten Ausführungsbeispiel, und auf eine wiederholende Beschreibung wird verzichtet.

Das zweite Ausführungsbeispiel von Fig. 4 unterscheidet sich von der in Fig. 1 dargestellten Ausführungsform in der Ausgestaltung der Strahlungsleiteinrichtung. Die Strahlungsleiteinrichtung weist in diesem Fall einen ersten Hohlleiter 32, der dem Sender 12 zugeordnet ist, und einen zweiten Hohlleiter 34, der dem Empfänger 14 zugeordnet ist, auf. Die beiden Hohlleiter 32, 34 ersetzen den Blendenrahmen 16 und sind naturgemäß an ihren Innenflächen reflektierend ausgebildet, d.h. entsprechend beschichtet oder insgesamt aus einem entsprechenden Material ausgebildet. Im Bereich zur Abdeckung 24 hin sind die beiden Hohlleiter 32, 34 jeweils nach innen, d.h. in Richtung zum jeweils anderen Hohlleiter, geneigt ausgebildet.

Diese Konstruktion des optischen Sensors mit den beiden Hohlleitern 32, 34 bewirkt die gleichen Vorteile wie im oben beschriebenen ersten Ausführungsbeispiel.

Fig. 5 zeigt schematisch den Aufbau eines optischen Sensors gemäß einem dritten Ausführungsbeispiel der Erfindung. Gleiche bzw. entsprechende Komponenten sind dabei mit den gleichen Bezugsziffern versehen wie im obigen ersten Ausführungsbeispiel, weshalb eine erneute Beschreibung weggelassen ist.

Insbesondere bei größeren Abständen zwischen Sender 12 / Empfänger 14 und Abdeckung 24 kann es für eine bessere Auswertbarkeit der Signale von Vorteil sein, als Strahlungsleiteinrichtung anstelle des einfachen Blendenrahmens 16 Lichtleiter einzusetzen. So enthält der optische Sensor von Fig. 5 einen ersten Lichtleiter 36, der dem Sender 12 zugeordnet ist, und einen zweiten Lichtleiter 38, der dem Empfänger 14 zugeordnet ist.

Zur Verbreiterung der Abstrahlcharakteristik 26 des Senders 12 und der Empfangscharakteristik 28 des Empfängers 14 sind die der Abdeckung 24 zugewandten Stirnflächen der jeweiligen Lichtleiter 36, 38 diffus streuend (z.B. aufgeraut oder eingetrübt) ausgebildet.

Außerdem sind die beiden Lichtleiter 36, 38 insgesamt aufeinander zu geneigt angeordnet, wie in Fig. 5 dargestellt. Alternativ können die Lichtleiter 36, 38 auch nur in dem Bereich zur Abdeckung 24 hin entsprechend geneigt ausgebildet oder mit entsprechend angeschrägten Austritts- bzw. Eintrittsflächen ausgebildet sein. Durch die Schrägstellung der Lichtleiter 36, 38 werden auch die entsprechenden Charakteristiken aufeinander zu geneigt.

Insgesamt können so auch im dritten Ausführungsbeispiel die gleichen Vorteile erzielt werden, wie sie oben in Zusammenhang mit dem ersten Ausführungsbeispiel ausführlich beschrieben worden sind.

### BEZUGSZIFFERNLISTE

- 10: Leiterplatte
- 12: Sender
- 14: Empfänger
- 16: Blendenrahmen
- 18: Austrittsöffnung
- 20: Eintrittsöffnung
- 22: Trennwand
- 24: Abdeckung
- 26: Abstrahlcharakteristik
- 28: Empfangscharakteristik
- 30: Kreuzungsbereich
- 32: erster Hohlleiter
- 34: zweiter Hohlleiter
- 36: erster Lichtleiter
- 38: zweiter Lichtleiter

## Patentansprüche

1. Optischer Sensor, mit
einem elektromagnetische Strahlung aussendenden Sender (12);
einem elektromagnetische Strahlung empfangenden Empfänger (14);
einer für die elektromagnetische Strahlung zumindest teildurchlässigen Abdeckung (24), hinter der der Sender (12) und der Empfänger (14) angeordnet sind; und
einer Strahlungsleiteinrichtung (16; 32, 34; 36, 38), die zwischen dem Sender (12) und dem Empfänger (14) einerseits und der Abdeckung (24) andererseits vorgesehen ist, um die vom Sender (12) ausgesendete Strahlung zur Abdeckung (24) zu leiten und die durch die Abdeckung (24) eindringende reflektierte Strahlung zum Empfänger (14) zu leiten,
**dadurch gekennzeichnet,**
**dass** die Strahlungsleiteinrichtung (16; 32, 34; 36, 38) so ausgebildet ist, dass die Abstrahlcharakteristik (26) des Senders (12) aus der Abdeckung (24) heraus und/oder die Empfangscharakteristik (28) des Empfängers (14) in die Abdeckung (24) hinein verbreitert sind.

2. Optischer Sensor nach Anspruch 1,
**dadurch gekennzeichnet,**
**dass** die Strahlungsleiteinrichtung (16; 32, 34; 36, 38) ferner so ausgebildet ist, dass die Abstrahlcharakteristik (26) des Senders (12) aus der Abdeckung (24) heraus in Richtung zur Empfangscharakteristik (28) des Empfängers (14) in die Abdeckung (24) hinein geneigt ist und/oder die Empfangscharakteristik (28) des Empfängers (14) in die Abdeckung (24) hinein in Richtung zur Abstrahlcharakteristik (26) des Senders (12) aus der Abdeckung (24) heraus geneigt ist.

3. Optischer Sensor, mit
einem elektromagnetische Strahlung aussendenden Sender (12);
einem elektromagnetische Strahlung empfangenden Empfänger (14);
einer für die elektromagnetische Strahlung zumindest teildurchlässigen Abdeckung (24), hinter der der Sender (12) und der Empfänger (14) angeordnet sind; und
einer Strahlungsleiteinrichtung (16; 32, 34; 36, 38), die zwischen dem Sender (12) und dem Empfänger (14) einerseits und der Abdeckung (24) andererseits vorgesehen ist, um die vom Sender (12) ausgesendete Strahlung zur Abdeckung (24) zu leiten und die durch die Abdeckung (24) eindringende reflektierte Strahlung zum Empfänger (14) zu leiten,
**dadurch gekennzeichnet,**
**dass** die Strahlungsleiteinrichtung (16; 32, 34; 36, 38) so ausgebildet ist, dass die Abstrahlcharakteristik (26) des Senders (12) aus der Abdeckung (24) heraus in Richtung zur Empfangscharakteristik (28) des Empfängers (14) in die Abdeckung (24) hinein geneigt ist und/oder die Empfangscharakteristik (28) des Empfängers (14) in die Abdeckung (24) hinein in Richtung zur Abstrahlcharakteristik (26) des Senders (12) aus der Abdeckung (24) heraus geneigt ist.

4. Optischer Sensor nach Anspruch 3,
**dadurch gekennzeichnet,**
**dass** die Strahlungsleiteinrichtung (16; 32, 34; 36, 38) ferner so ausgebildet ist, dass die Abstrahlcharakteristik (26) des Senders (12) aus der Abdeckung (24) heraus und/oder die Empfangscharakteristik (28) des Empfängers (14) in die Abdeckung (24) hinein verbreitert sind.

5. Optischer Sensor nach einem der Ansprüche 1 bis 4,
**dadurch gekennzeichnet,**
**dass** die Strahlungsleiteinrichtung (16) ein Blendenrahmen ist, der den Sender (12) und den Empfänger (14) umgibt und an seiner der Abdeckung (24) zugewandten Seite eine dem Sender (12) zugeordnete Austrittsöffnung (18) und eine dem Empfänger (14) zugeordnete Eintrittsöffnung (20) aufweist; und
**dass** die Innenflächen des Blendenrahmens (16) zumindest teilweise die elektromagnetische Strahlung reflektierend ausgebildet sind.

6. Optischer Sensor nach einem der Ansprüche 1 bis 4,
**dadurch gekennzeichnet,**
**dass** die Strahlungsleiteinrichtung (32, 34) einen ersten, dem Sender (12) zugeordneten Lichtleiter (32) und einen zweiten, dem Empfänger (14) zugeordneten Lichtleiter (34) aufweist; und
**dass** die der Abdeckung (24) zugewandte Stirnseite des ersten und/oder des zweiten Lichtleiters (32, 34) diffus streuend ausgebildet ist.

7. Optischer Sensor nach einem der Ansprüche 1 bis 4,
**dadurch gekennzeichnet,**
**dass** die Strahlungsleiteinrichtung (36, 38) einen ersten, dem Sender (12) zugeordneten Hohlleiter (36) und einen zweiten, dem Empfänger (14) zugeordneten Hohlleiter (38) aufweist.

8. Optischer Sensor nach einem der Ansprüche 1 bis 5,
**dadurch gekennzeichnet,**
**dass** die Strahlungsleiteinrichtung (16) ein Blendenrahmen ist, der den Sender (12) und den Empfänger (14) umgibt und an seiner der Abdeckung (24) zugewandten Seite eine dem Sender (12) zugeordnete Austrittsöffnung (18) und eine dem Empfänger (14) zugeordnete Eintrittsöffnung (20) aufweist; und
**dass** der Blendenrahmen (16) in Richtung zur Abdeckung (24) hin nach innen verengt ausgebildet ist.

9. Optischer Sensor nach einem der Ansprüche 1 bis 4 und 6,
**dadurch gekennzeichnet,**
**dass** die Strahlungsleiteinrichtung (32, 34) einen ersten, dem Sender (12) zugeordneten Lichtleiter (32) und einen zweiten, dem Empfänger (14) zugeordneten Lichtleiter (34) aufweist; und
**dass** der erste und/oder der zweite Lichtleiter (32, 34) in Richtung zur Abdeckung (24) hin nach innen geneigt angeordnet sind und/oder in dem der Abdeckung (24) zugewandten Bereich schräg nach innen verlaufend ausgebildet sind.

10. Optischer Sensor nach einem der Ansprüche 1 bis 4 und 7,
**dadurch gekennzeichnet,**
**dass** die Strahlungsleiteinrichtung (36, 38) einen ersten, dem Sender (12) zugeordneten Hohlleiter (36) und einen zweiten, dem Empfänger (14) zugeordneten Hohlleiter (38) aufweist; und
**dass** der erste und/oder der zweite Hohlleiter (36, 38) in Richtung zur Abdeckung (24) hin nach innen geneigt angeordnet sind und/oder in dem der Abdeckung (24) zugewandten Bereich schräg nach innen verlaufend ausgebildet sind.
